Europäisches Patentamt

European Patent Office

Office européen des brevets

(11) Publication number: **0 367 108**
**A2**

## (12) EUROPEAN PATENT APPLICATION

(21) Application number: 89119907.7

(51) Int. Cl.⁵: **G08B 13/191**

(22) Date of filing: 26.10.89

(30) Priority: 31.10.88 US 268077

(43) Date of publication of application:
09.05.90 Bulletin 90/19

(84) Designated Contracting States:
DE FR GB

(71) Applicant: **HONEYWELL INC.**
**Honeywell Plaza**
**Minneapolis Minnesota 55408(US)**

(72) Inventor: **Hartley, Martha A.**
**1222 Mammoth Road**
**Dracut Massachusetts 01826(US)**
Inventor: **Rakers, Lawrence D.**
**33 University Avenue**
**Burlington Massachusetts 01803(US)**

(74) Representative: **Rentzsch, Heinz et al**
**Honeywell Europe S.A. Holding KG Patent &**
**License Dept. Postfach 10 08 65**
**Kaiserleistrasse 39**
**D-6050 Offenbach am Main(DE)**

(54) Electrical interconnector for infrared detector arrays and method for its fabrication.

(57) An electrical interconnect structure for pyroelectric detector arrays includes a bump structure (16) having a polyimide core (18) surrounded by a layer (20) of chromium indium and integrally mounted to a thin film (14) of chromium which, in turn, is applied to a planar wafer (12) of lithium tantalate.

FIG. 2

EP 0 367 108 A2

# ELECTRICAL INTERCONNECTOR FOR INFRARED DETECTOR ARRAYS AND METHOD FOR ITS FABRICATION

This invention relates to radiation sensor systems, such as infrared sensing systems and, in particular, relates to electrical connectors for infrared detectors comprising a bump structure having a rigid core of thermally insulating material covered by a layer of metal, and to infrared detector devices employing such interconnection structures.

## BACKGROUND OF THE INVENTION

Present methods of interconnecting pyroelectric detector arrays to their associated electronics include using so-called "bump" connectors between the detector array substrate and the circuitry substrate. These bump connectors or contacts extend some distance above the surface of the material on which the contact is formed, so that electrical connection may be made through a layer of nonconductive material, for example. Prior art bump connectors are usually comprised of a solid metal. such as indium. Under appropriate pressure and temperature conditions, such bumps would allow for cold welding between bumps of like metals to achieve an interconnection from the electronics to the detector.

One major disadvantage of using such solid metal bumps for electrical interconnection is that solid metal bumps are highly thermally conductive and draw heat away from the detector to which they are connected. This results in a degraded thermal image signal from the detector. Yet another drawback of the known structures used for interconnecting detectors through bumps is that the cold weld formed often results in an unreliable electrical and mechanical interconnection because the indium bumps do not always weld together properly.

It is the main object of the invention to overcome the disadvantages of the prior art by providing a highly reliable method of interconnection which also offers a lower thermal conduction path. This is achieved by the invention as characterized in the independent claims.

The invention is an electrical interconnect structure comprising a substrate and a bump structure mounted on the substrate wherein the bump structure further comprises a metal evaporated around a rigid core material which thermally insulates a detector interconnected by the bump.

The substrate may comprise, for example, lithium tantalate (Li Ta O$_3$ hereinafter referred to as "LTO") having a layer of chromium on one surface. The metal used to envelope the core material may be chromium and indium in the preferred embodiment of the invention and the core material may advantageously be comprised of polyimide.

The invention provides a highly reliable method of interconnection for infrared detector arrays. This electrical interconnection offers a lower thermal conductive path than such interconnections used in the prior art. The invention provides highly improved cold welded interconnections and permits manufacturing of infrared detector devices having highly reliable electrical interconnects between the detector array and the associated electronics. The interconnects between the detector array and associated electronics exhibit a lower amount of thermal conduction than prior art devices.

Other objects, advantages and features of the invention will become apparent from the subclaims and through reference to the detailed description of the preferred embodiment, claims and drawings herein wherein like numerals refer to like elements.

## BRIEF DESCRIPTION OF THE DRAWINGS

Figure 1 shows a planar top view of the bump interconnection of the invention.

Figure 2 illustrates schematically a side cross-cut view of the electrical bump interconnection of the invention taken along line 2-2 of Figure 1.

Figure 3 shows one embodiment of an infrared detector device employing rigid core interconnections in cross-sectional side view.

## DETAILED DESCRIPTION OF THE PREFERRED EMBODIMENTS

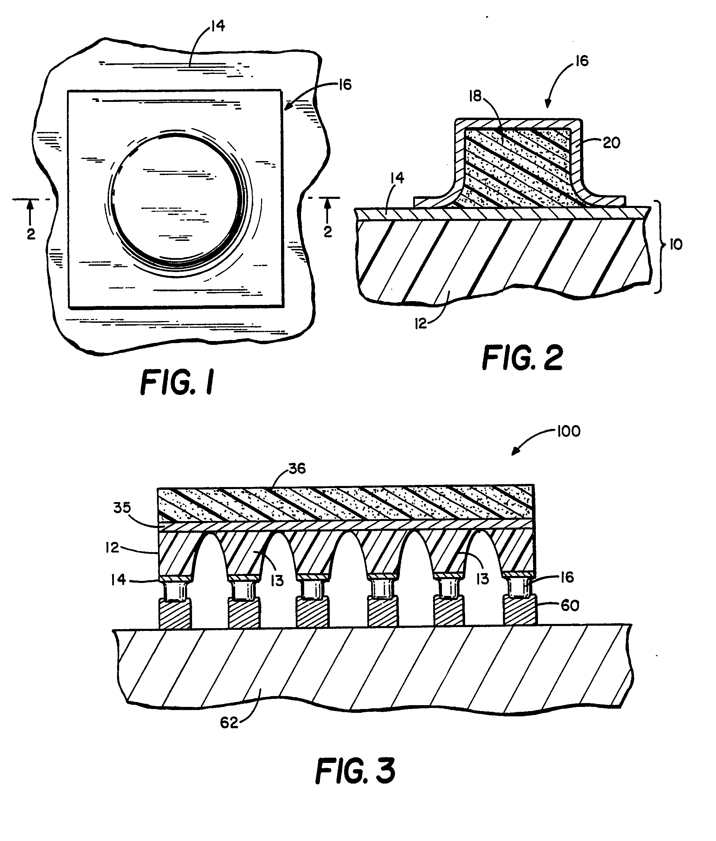

As is best shown in Figures 1 and 2, the electrical inter-connection of the invention comprises a substrate 10, and an electrical interconnect bump structure 16 integrally attached to the substrate 10. The electrical interconnect bump structure comprises an inner core 18 and an outer layer 20 covering the inner core.

In one embodiment of the invention the substrate 10 is preferably comprised of a wafer made of lithium tantalate. In an alternative embodiment of the invention, the substrate 10 may comprise a first layer 14 and a second layer 12. For example, the second layer may be a lithium tantalate wafer 12 advantageously covered by a first layer of metal film 14 of, for example, chromium. The core 18 is preferably comprised of polyimide. One such polyimide found to be advantageously used as the core material is Selectilux™ HTR-3-200, which is manufactured by E. Merck, a German chemical company of Darmstadt, F.R.G.

Several experiments were conducted by the Electro-Optics Division of Honeywell, Inc., in Lexington, Massachusetts, some polyimide core bumps as decribed above, were made on both real and simulated detector arrays. The arrays were then cold welded or "bumped" to CCD electrical components. The polyimide core bump structure was found to exhibit a very strong cold weld to a solid indium bump. The polyimide core bumps showed an improved cold weld over standard all-indium bumps. It is hypothesized that this is due to the rigidity of the polyimide core. The core apparently acts as a battering ram and breaks up the indium oxide on the outer edges of the bumps. This allows true indium cold welding to take place. Further, actual arrays made with polyimide core bumps showed improved video imagery due to lower thermal conduction.

## ILLUSTRATIVE EXAMPLE OF PROCESSING OF THE BUMP

In order to further explain the invention, an illustrative example of one process used in forming such interconnects will prove useful and is described in detail as follows.

The illustrative polyimide core bump process is a low temperature process and advantageously uses a special photosensitive polyimide bump called Selectilux™ HTR-3-200 as described above. This process requires a special developer, Selectilast™ HTR-D-2, also manufactured by Merck. This polyimide is photosensitive and essentially acts very much like a negative photoresist. Those skilled in the art will recognize that polyimides other than Selectilux™ HTR-3-200 may be used as well as other organic materials like photoresist. The process steps used in the example were as follows:

1. Selectilux HTR-3-200 was spun onto a chromium metal layer at 5000 rpm for 30 seconds. The resulting layer of polyimide was about 8 microns thick.

2. The part was next soft baked at 70°C for 3.5 hours and air-dried for a short period of time.

3. The polyimide was exposed for about 105 seconds using a dark field mask and the polyimide was developed for 150 to 180 seconds with a spray developer, Selectiplast™ HTR-D-2. The part was rinsed in isopropyl alcohol.

4. Next, Shipley 4620 with imidazole added was spun on at 5000 rpm for 30 seconds. Shipley 4620 is manufactured by American Hoechst Corporation, AZ Photoresist Products of Somerville. New Jersey. A mask with a pattern larger than the polyimide core was used. See Figure 1 for a relative view of the result of using the different sized patterns of photo masks in processing the electrical interconnect bump of the invention. Image reversal techniques were used to enhance the eventual metal liftoff. As part of this process, the resist and polyimide saw a 90°C bake. These bakes also serve as the cure for the polyimide. After the resist was developed. the part was rinsed and then cleaned in an $O_2$ plasma.

5. A metal film was then evaporated over the polyimide core using a planetary fixture. The film used in this example of the invention was a 100A of chrome and 10,000A of indium.

6. The part bearing the polyimide core bumps was then bump connected to CCD electronics having pure indium bumps using 3168g of bumping force.

The above processing steps are meant to serve as an illustrative example of one way to make the electrical interconnects of the invention. Those skilled in the art will recognize that there are various other methods and modifications of the above process which will still accomplish the invention.

## INFRARED DETECTOR ARRAY

Referring now to Figure 3, one embodiment of an infrared detector device 100 employing rigid core interconnections 16 is shown in a cross-sectional side view. The detector device 100 comprises a protective layer of polyimide 36 applied by well-known methods, such as is described above, over a first metal layer 35 which is evaporated onto a substrate 12 comprised of a thermal-sensitive material suitable for detecting infrared radiation and etched appropriately to form individual detector elements 13. A metal layer 14 may be applied as explained above with respect to Figures 1 and 2. An interconnect bump 16 is formed on each detector element according to a method such as is detailed above. The interconnect bump 16 is comprised of materials as explained above with reference to Figures 1 and 2. The interconnect bumps 16 are cold welded to metallic bumps 60 which are, in turn, connected to electronics on CCD chip 62 for processing electronic signals generated by the detector array comprised of layers 35 and 36, and the etched wafer 12. Such processing electronics are well known and may comprise various analog or digital techniques depending upon the application or environment in which the infrared detectors are to be deployed.

In one embodiment of the invention, the rigid core interconnections are comprised of a polyimide core covered by a layer of a metal consisting of chromium and indium. The first metal layer 35 and the second layer 14, if used, may advantageously be comprised of chromium. The thermal sensitive material 12 which is etched into individual detector elements 13 may be comprised of LTO. Those skilled in the art will recognize that other thermal sensitive materials may be used. The solid metal interconnect bump 60 may advantageously be comprised of indium which is, in turn, attached to a chip 62 comprised mainly of silicon having LSI or VLSI components embedded therein.

It should be understood that various combinations of the techniques and principles taught by the invention may be utilized without departing from the spirit and scope of the invention.

## Claims

1. An electrical interconnection structure comprising:

a) a substrate (10); and

b) a bump structure (16) mounted on the substrate **characterized in that** the bump structure (16) comprises a first metal layer (20) deposited around a rigid core material (18).

2. The structure of claim 1, **characterized in that** the substrate (10) comprises a wafer of lithium tantalate.

3. The structure of claim 2, **characterized in that** the substrate (10) comprises a lithium tantalate wafer (12) having one surface covered by a second metal layer (14).

4. The structure of claim 3, **characterized in that** the second metal layer (14) comprises chromium.

5. The structure according to one of the preceding claims, **characterized in that** the deposited first metal layer (20) comprises chromium indium.

6. A low thermal conductive electrical interconnect structure for pyroelectric detector arrays, **characterized by:**

a) a substrate (10) comprising a wafer (12) of lithium tantalate having a top surface covered by a metal film (14) of chromium; and

b) a bump structure (16) mounted on the substrate (10) wherein the bump structure (16) comprises a rigid core material (18) having a metal layer (20) of chromium indium enveloping the rigid core material (18).

7. A structure according to one of the preceding claims, **characterized in that** the rigid core material (18) is polyimide.

8. An improved method for fabricating an electrical interconnector for infrared detector arrays comprising the steps of:

a) spinning a photosensitive polyimide (18) onto a metal layer (14);

b) soft baking the polyimide (18) and metal (14) structure (18, 14) formed in step (a);

c) exposing and developing the spun polyimide layer (18);

d) spinning a photoresist onto the polyimide-metal structure (18, 14) using a mask larger than the polyimide core;

e) evaporating a metal film (20) onto the polyimide core; and

f) lifting the photoresist material off of the structure (18, 14).

9. The method of claim 7 applying image reversal techniques to enhance the metal liftoff.

10. The method of claim 8 or 9 wherein the metal layer (14) is comprised of chromium.

32123·14

FIG. 1

FIG. 2

FIG. 3